Europäisches Patentamt

**European Patent Office**

Office européen des brevets

(19)

(11) Publication number: **0 005 468**
**B1**

(12) **EUROPEAN PATENT SPECIFICATION**

(45) Date of publication of patent specification: **05.10.83**

(51) Int. Cl.³: **H 05 K 13/04, B 65 G 1/00**

(21) Application number: **79101275.0**

(22) Date of filing: **27.04.79**

(54) **Machine for automatically inserting parallel lead electronic components into a printed circuit board.**

(30) Priority: **02.05.78 JP 53161/78**

(43) Date of publication of application:
**28.11.79 Bulletin 79/24**

(45) Publication of the grant of the patent:
**05.10.83 Bulletin 83/40**

(84) Designated Contracting States:
**DE FR GB NL**

(56) References cited:
**US - A - 3 539 086**

(73) Proprietor: **TDK Corporation**
**13-1, Nihonbashi 1-chomo, Chuo-Ku**
**Tokyo-to (JP)**

(72) Inventor: **Takahashi, Tetsuo, c/o Tokyo Denki Kagaku**
**Kogyo Kabushiki Kaisha, 13-1, Nihonbashi 1-Chome**
**Chuo-Ku Tokyo-to (JP)**
Inventor: **Taguchi, Yoshinobu c/o Tokyo Denki Kagaku**
**Kogyo Kabushiki Kaisha, 13-1, Nihonbashi 1-chome**
**Chuo-ku Tokyo-to (JP)**
Inventor: **Harigane, Kotaro c/o Tokyo Denki Kagaku**
**Kogyo Kabushiki Kaisha, 13-1, Nihonbashi 1-chome**
**Chuo-ku Tokyo-to (JP)**
Inventor: **Ito, Tetsuro c/o Tokyo Denki Kagaku**
**Kogyo Kabushiki Kaisha, 13-1, Nihonbashi 1-chome**
**Chuo-ku Tokyo-to (JP)**
Inventor: **Kato, Akihiro c/o Tokyo Denki Kagaku**
**Kogyo Kabushiki Kaisha, 13-1, Nihonbashi 1-chome**
**Chuo-ku Tokyo-to (JP)**

Courier Press, Leamington Spa, England

(74) Representative: **Lotterhos, Hans Walter, Dr.-Ing.**
**Lichtensteinstrasse 3**
**D-6000 Frankfurt am Main 1 (DE)**

## Machine for automatically inserting parallel lead electronic components into a printed circuit board

The present invention relates to an automatically inserting machine for separating electronic components such as condensers, resistances, diodes, transistors or the like from electronic component web carriers of radial lead electronic components or parallel lead electronic components where one of axial leads is bent by 180° and made parallel to the other axial lead and inserting the separated electronic components into lead insert holes on a printed circuit board or the like.

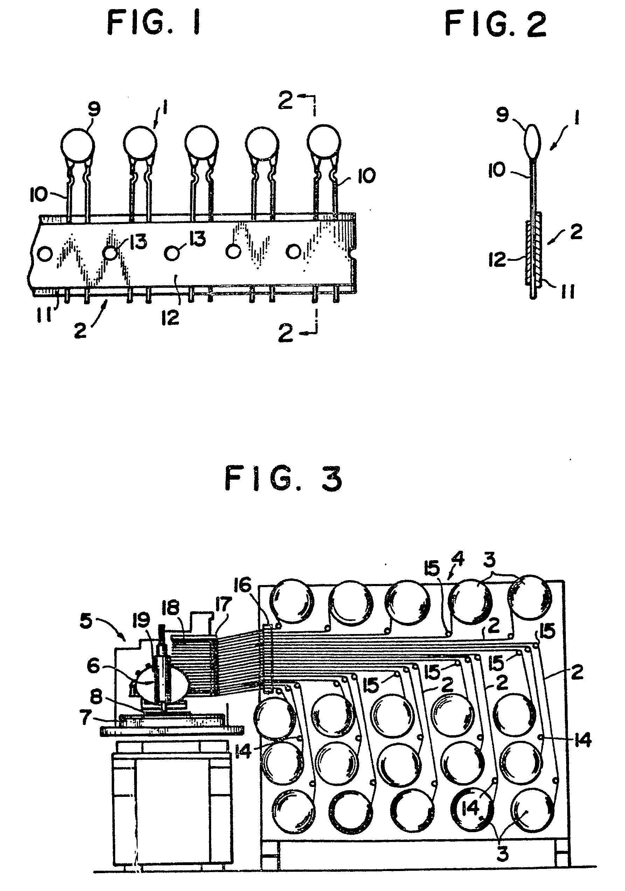

In the recently developed machine for inserting electronic components in a printed circuit board of this invention an electronic component web carrier 2 including a series of many electronic components 1 as shown in Fig 1, is wound on a reel 3, a plurality of such reels 3 are held on a holding plate 4 as shown in Fig. 3, the electronic component web carriers 2 unwound and taken out from the respective reels 3 are guided to an automatically inserting machine 5 to cut the respective electronic components from the electronic component web carriers 2, and the separated electronic components 1 are held by the top end of inserting means 6 and inserted into predetermined holes of a printed circuit board 8 placed on a table 7.

In the electronic component web carrier 2, leads 10 led from electronic elements 9 are bonded to a holding web 11 by an adhesive tape 12 and fixed to the web 11 equidistantly in parallel to one another, and positioning and feeding holes 13 are equidistantly formed on the electronic component web carrier 2.

When a great number of electronic components are inserted in one printed circuit board 8, a great number of reels 3 on which web carriers of many different kinds of electronic components are wound, respectively, are arranged on the holding plate 4 as shown in Fig. 3, and the electronic component web carriers taken out from these reels 3 are introduced into the inserting apparatus through guides 16 and 17 by means of guide rollers 14 and feed rollers 15 and they are made to stand by on receiving shelves 18. Then, according to instructions of a program, electronic components of a predetermined electronic component web carrier are separated therefrom and they are transferred and fed to the inserting means 6 by transfer means 19, and predetermined electronic components are then inserted into predetermined holes of the printed circuit board.

The automatically inserting machine 5 of this type is better than conventional machines with respect to the inserting speed and reliability. However, since many kinds of electronic components are respectively selected and separated for insertion by one machine, a certain time is necessary for this selection and it is very difficult to shorten the operation time required for insertion of one electronic component.

If the automatically inserting machine is constructed so that one web carrier of electronic components is processed by one machine and a plurality of such inserting machines are arranged in series, it is possible to insert different kinds of electronic components in sequence, and the speed of insertion of electronic components can be increased over the inserting speed attainable in the machine disclosed in the U.S. Patent No. 4,054,988 granted to the applicant. That is, the inserting capacity is increased and the reliability of the inserting operation is remarkably enhanced.

It is therefore a primary object of the present invention to provide a machine for automatically inserting electronic components in which the inserting speed is increased over the inserting speed attainable in the machine disclosed in U.S. Patent No. 4,054,988, though the machine is small in the size and light in the weight.

In accordance with the present invention, this object can be attained by a machine for processing and inserting parallel lead electronic components from an electronic component web carrier carrying a plurality of parallel lead electronic components into lead receiving openings in a printed circuit board, which comprises a frame, feed means for feeding said electronic component web carrier, cutting means for separating each electronic component from said electronic component web carrier, insert means for receiving said each electronic component at a predetermined position and inserting same into said printed circuit board, and transfer means for transferring each said electronic component from said cutting means to said insert means, said transfer means including a lead-chuck mechanism adapted to grip a lead of said electronic component during separation and transfer of each said electronic component, characterized in that said cutting means (101, 102) includes a holding member (100a) for holding said leads (10) of said electronic component (1) obliquely to the vertical direction; and that said transfer means (35) includes a horizontal shaft (123), a chuck lever (127) rotatably supported around said horizontal shaft and for holding said lead-chuck mechanism (129), a slip off lever (126), also rotatably supported around said horizontal shaft and a slip off mechanism (145, 147) mounted on said slip off lever, for producing swinging motions between said holding member (100a) of said cutting means (101, 102) and said insert means (21).

The present invention will now be described in detail by reference to embodiments illustrated in the accompanying drawing.

Brief Description of the Drawing

Fig. 1 is a plan view showing an example of the electronic component web carrier.

Fig. 2 is a view showing the section taken along the line 2—2 in Fig. 1.

Fig. 3 is a front view showing an example of the conventional automatically inserting machine.

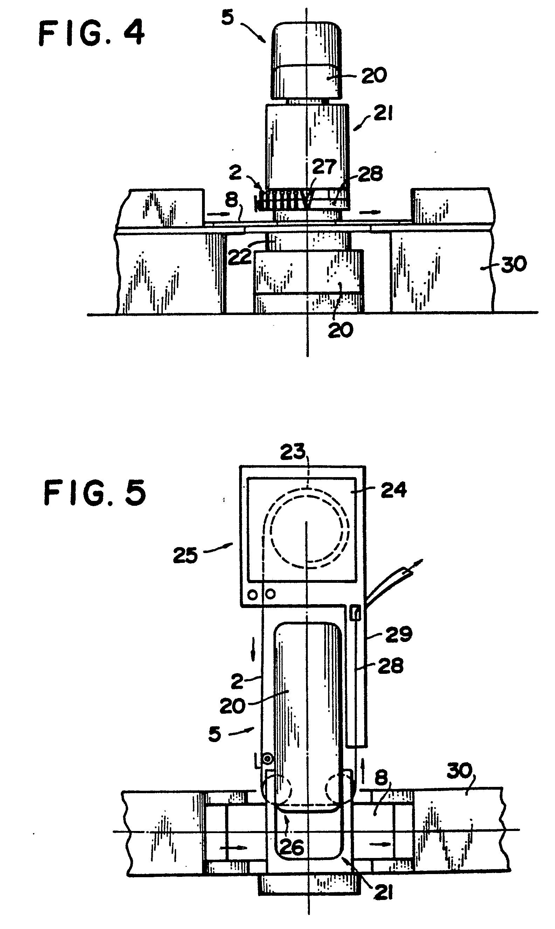

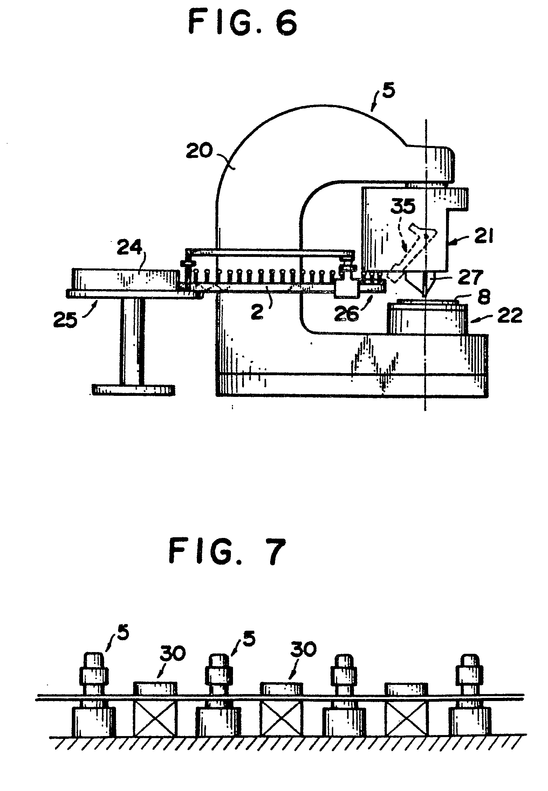

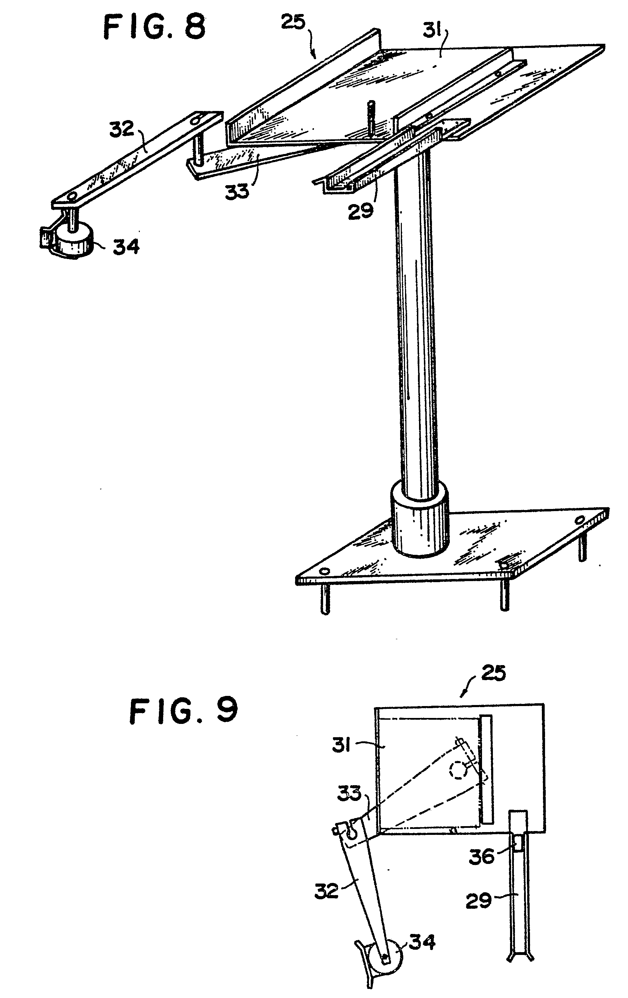

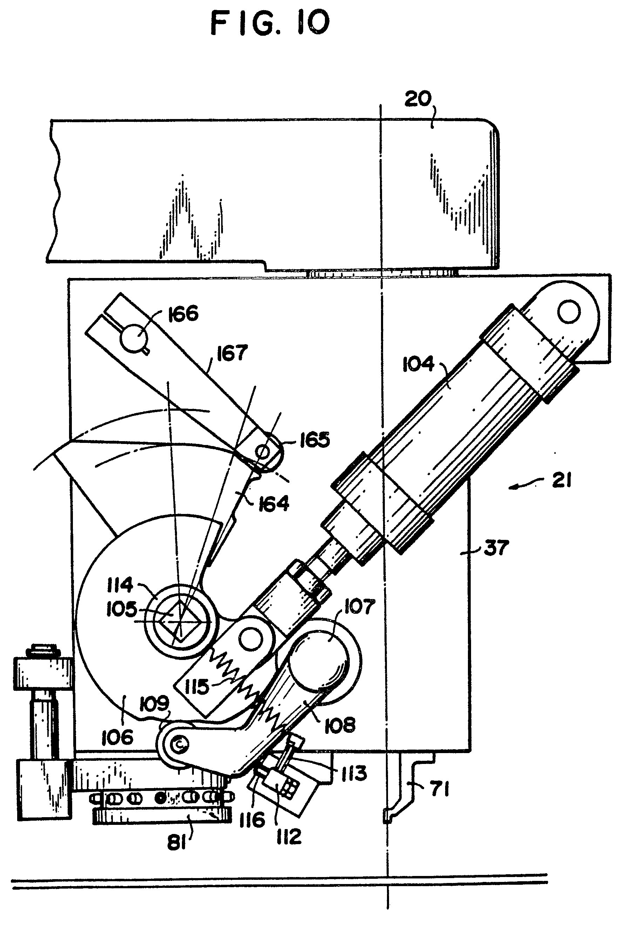

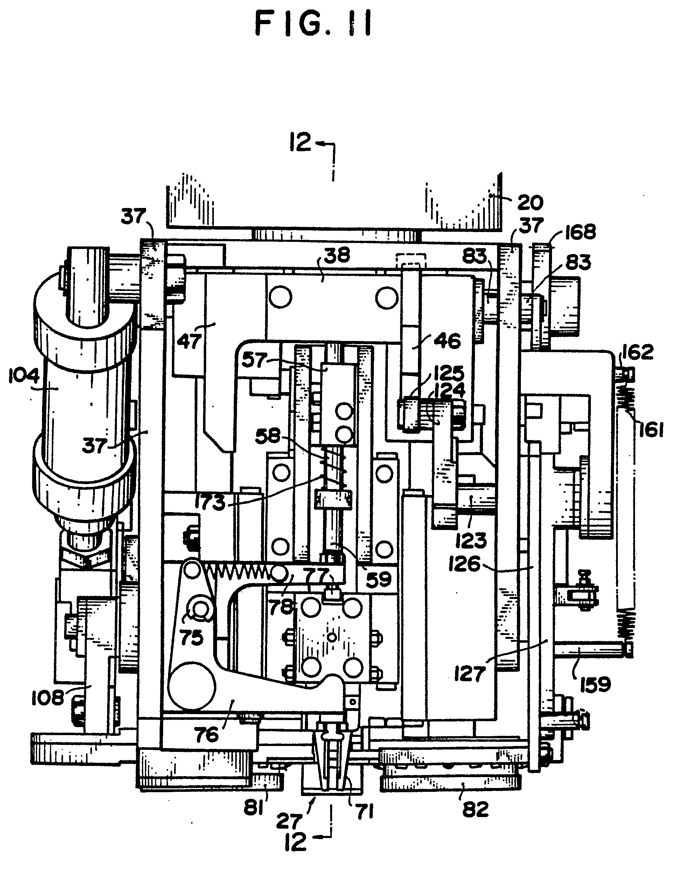

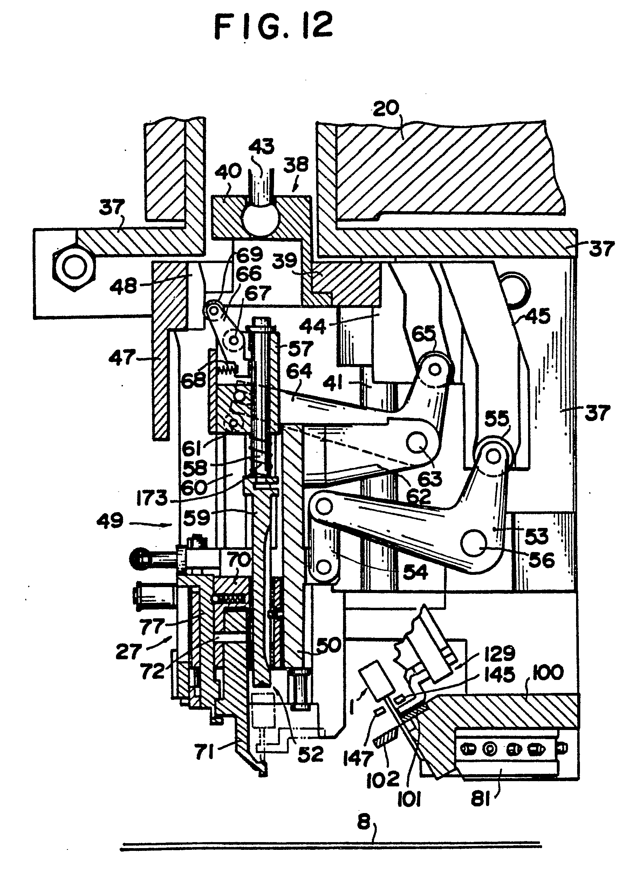

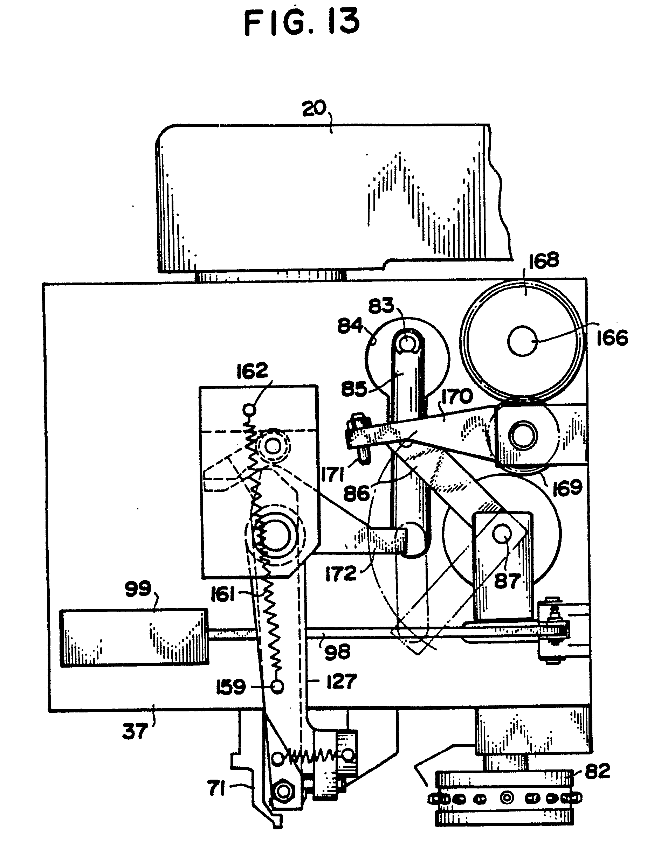

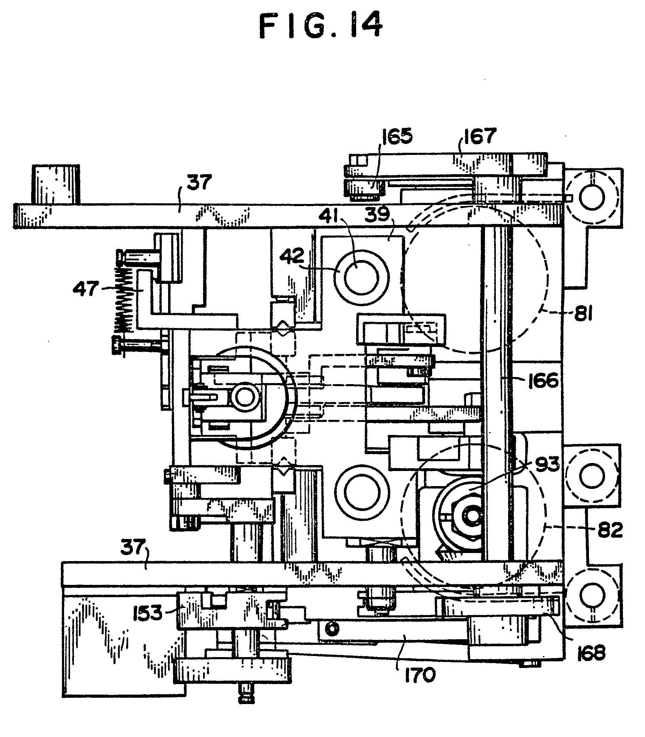

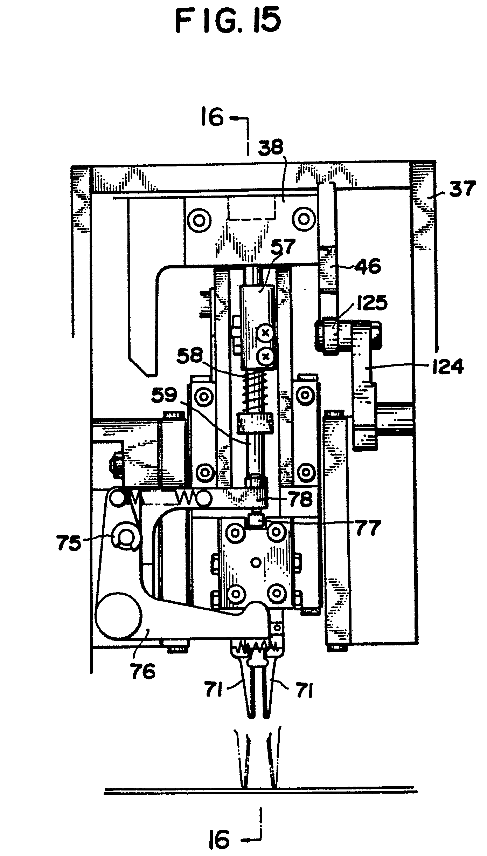

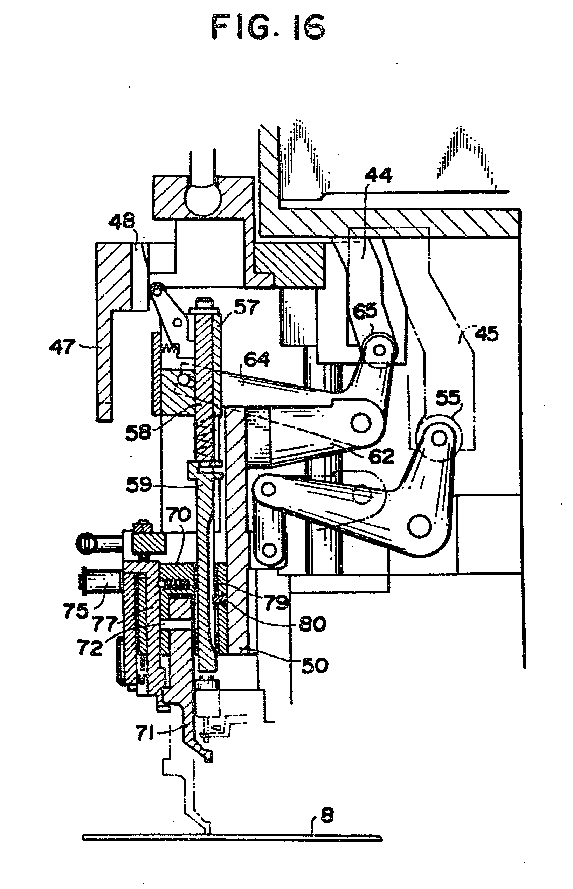

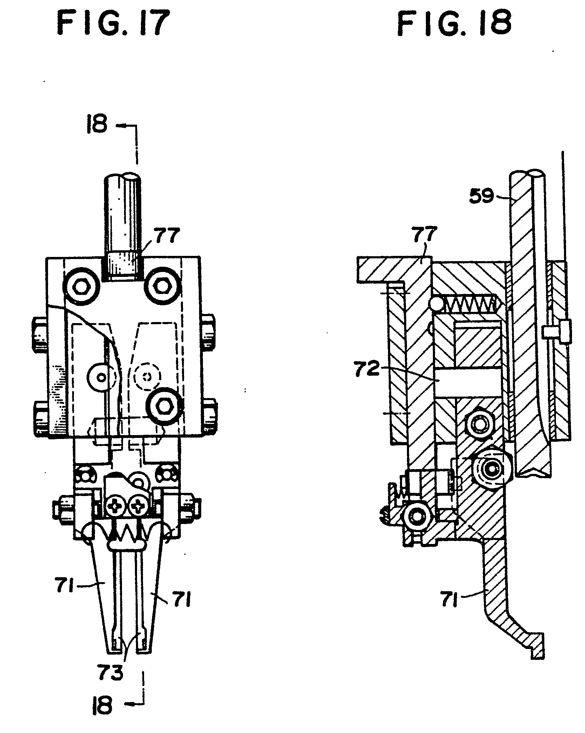

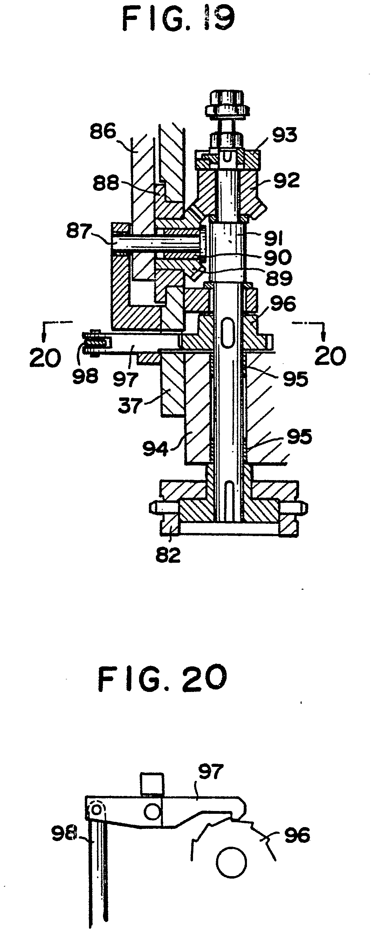

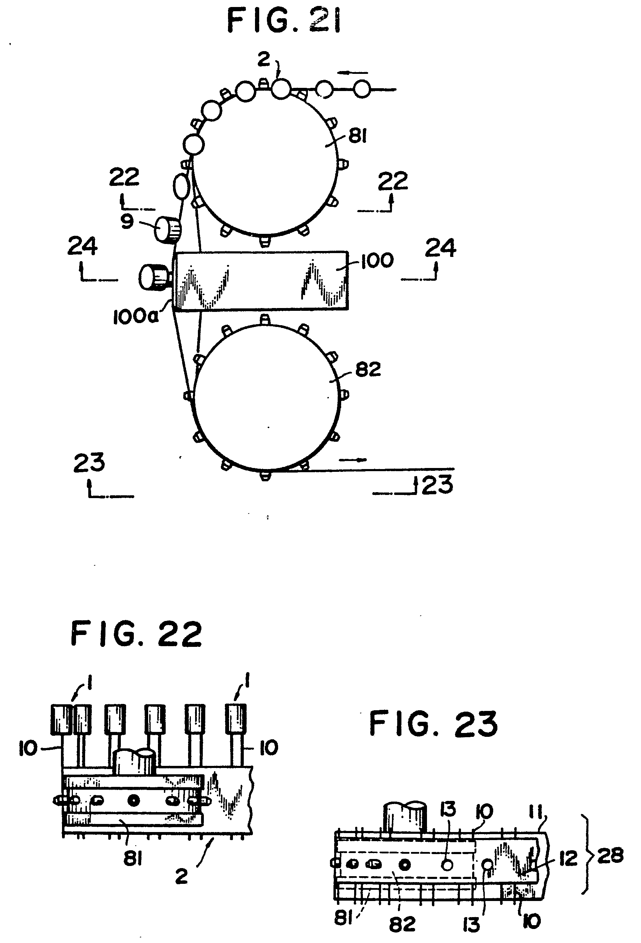

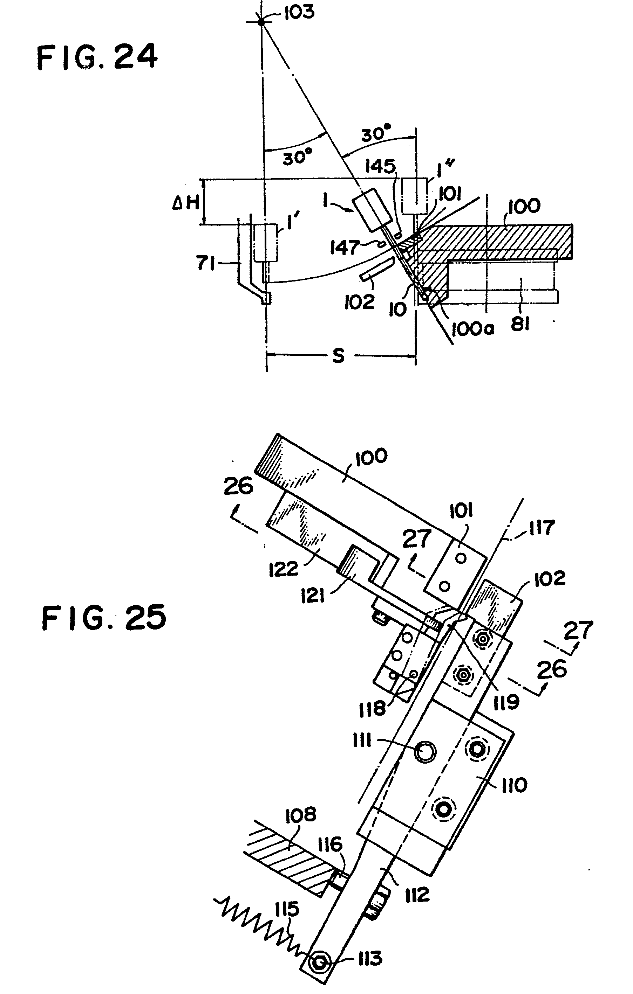

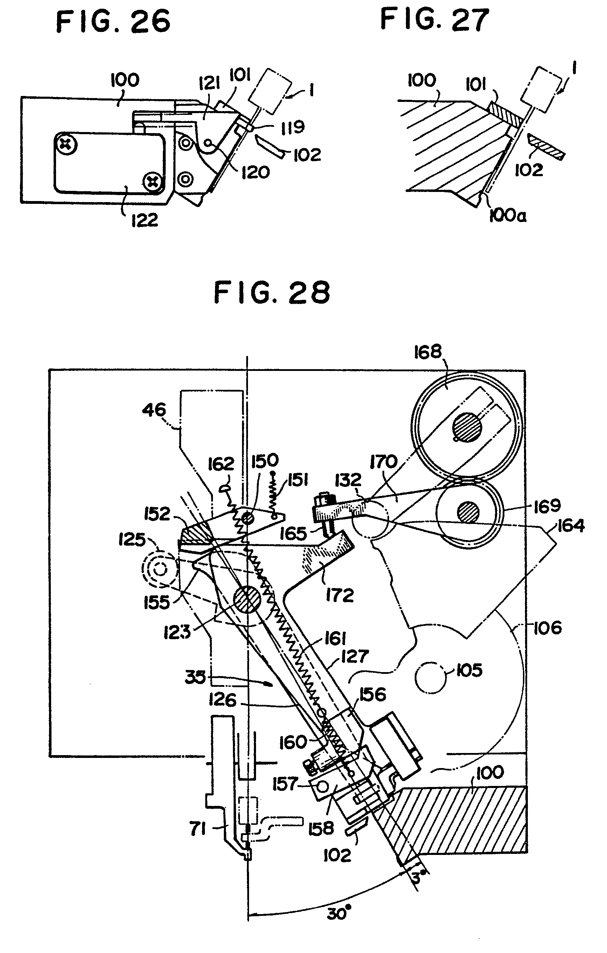

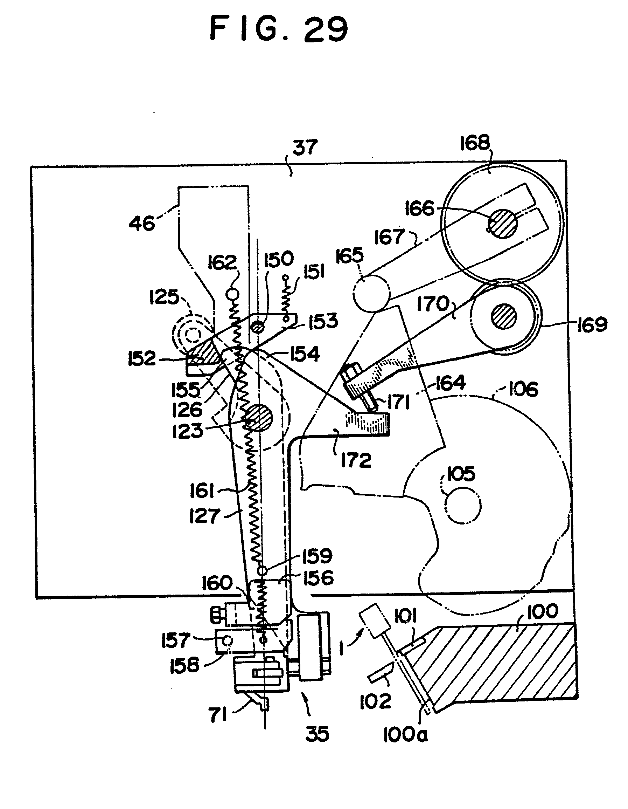

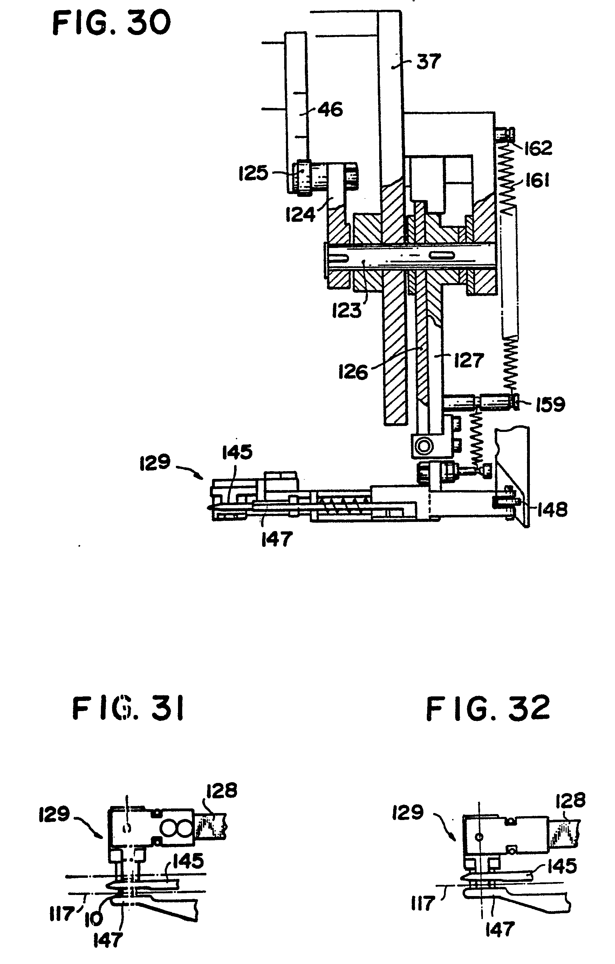

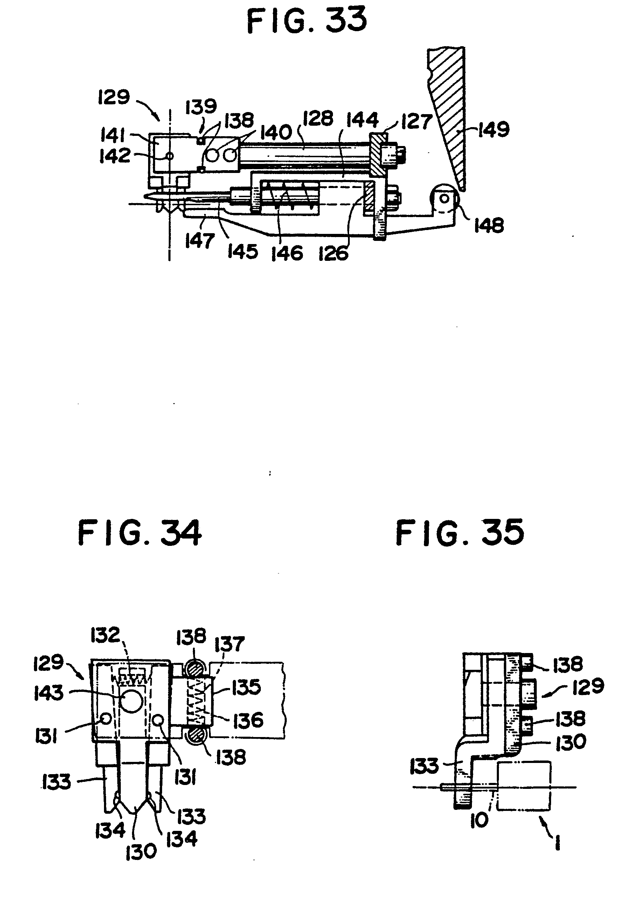

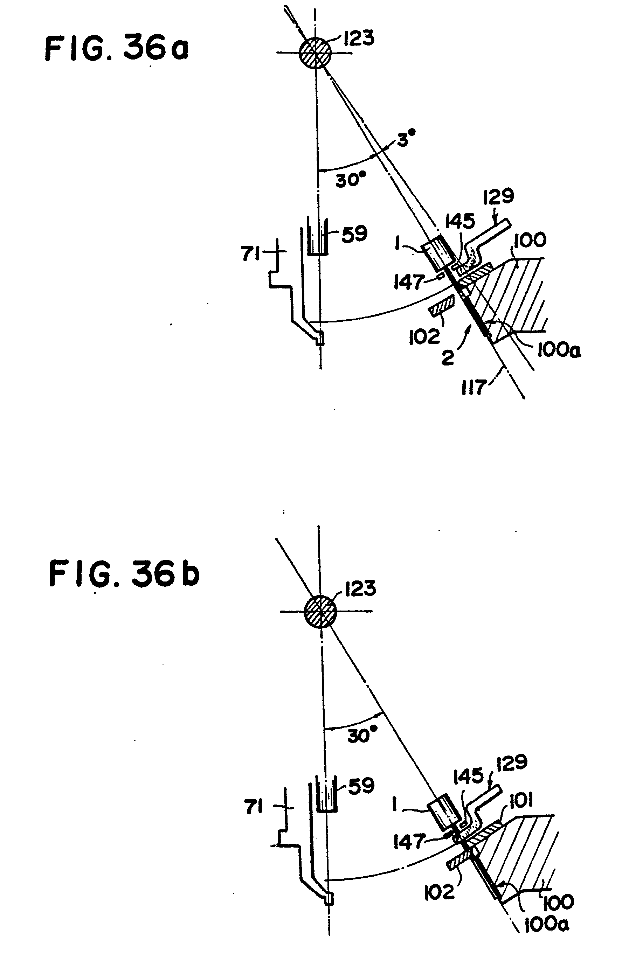

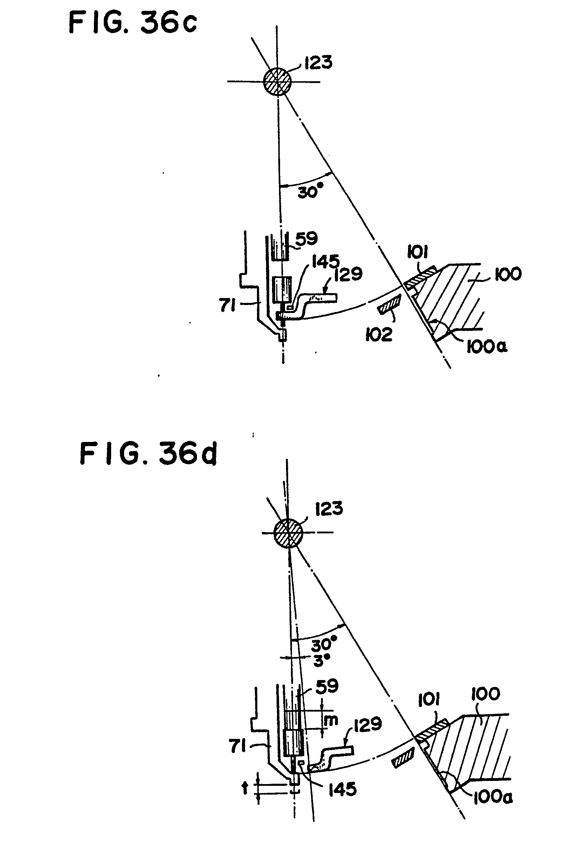

Figs. 4 to 36 are diagrams illustrating one embodiment of the present invention, in which Figs. 4, 5 and 6 are front, plan and side views of the machine, respectively, Fig. 7 is a front view showing a layout where a plurality of machines shown in Figs. 4, 5 and 6 are arranged in series, Fig. 8 is a perspective view showing feed means for feeding the electronic component web carrier, Fig. 9 is a front view of the feed means shown in Fig. 8, Fig. 10 is a view showing the left side of the inserting unit, Fig. 11 is a front view of the inserting unit, Fig. 12 is a side view showing the section taken along the line 12—12 in Fig. 11, Fig. 13 is a view showing the right side of the inserting unit, Fig. 14 is a plan view of the inserting unit, Fig. 15 is a front view of inserting means, Fig. 16 is a side view showing the section taken along the line 16—16 in Fig. 15, Fig. 17 is a front view of inserting and guiding means, Fig. 18 is a view showing the section taken along the line 18—18 in Fig. 17, Fig. 19 is a view showing the longitudinal section of the ratchet wheel shaft, Fig. 20 is a plan view showing the section taken along the line 20—20 in Fig. 19, Fig. 21 is a plan view of the ratchet wheel, Fig. 22 is a side view showing the section taken along the line 22—22 in Fig. 21, Fig. 23 is a side view showing the section taken along the line 23—23 in Fig. 21, Fig. 24 is a side view showing the section taken along the line 24—24 in Fig. 21, Fig. 25 is a plan view of cutting means, Fig. 26 is a view showing the section taken along the line 26—26 in Fig. 25, Fig. 27 is a view showing the section taken along the line 27—27 in Fig. 25, Figs. 28 and 29 are side views showing the vicinity of the chuck lever in different operation stages, Fig. 30 is a front view showing the state of Fig. 29, Figs. 31, 32 and 33 are front views of the chuck mechanism, wiper and lead press bar in different operation stages, Fig. 34 is a front view of the chuck mechanism, Fig. 35 is a side view of the chuck mechanism, and Figs. 36-(a), 36-(b), 36-(c) and 36-(d) are diagrams illustrating the operation steps in transfer means.

As shown in Figs. 4, 5 and 6, an automatically inserting machine 5 including the insert assembly according to the present invention comprises a unit 25 for containing electronic components therein, an inserting unit 21 supported on a machine frame 20 and a table unit 22. The containing unit 25 on which a carton 24 containing reel 23 of an electronic component web carrier 2 as shown in Fig. 1 is mounted is disposed to feed the electronic component web carrier 2 to the automatically inserting machine 5. The electronic component web carrier 2 taken out from the reel 23 is introduced into feed means 26 of the automatically inserting machine 5, and respective electronic components are separated from the web carrier 2 and transferred to inserting and guiding means 27 by transfer means 35 and they are inserted into predetermined holes of a printed circuit board 8 placed on the table unit 22 by said inserting and guiding means 27.

The remaining web carrier 28 from which the electronic components have been separated is guided onto a gutter 29 and discharged outside. The printed circuit boards 8 in which the predetermined electronic components have been inserted are delivered onto a table 30 by known delivery means and are fed to subsequent steps in sequence.

Fig. 7 illustrates a layout in which a plurality of automatically inserting machines according to the present invention are arranged in a line in series.

Figs. 8 and 9 illustrate one embodiment of the electronic component containing unit 25, which comprises a plate portion 31 on which the carton 24 (not shown) for containing an electronic component web carrier therein is placed, and arms 32 and 33 and guide roller 34 for guiding the electronic component web carrier 2 (shown in Fig. 1) to be fed to the inserting unit 21. Reference numeral 29 represents a gutter for guiding the web carrier 28 (not shown) from which electronic components have been separated, and a hole 36 is disposed to discharge this web carrier 28 to the outside.

The inserting unit 21 according to the present invention will now be described in detail.

Referring to Figs. 10 through 14, the inserting unit 21 comprises a unit frame 37 hung from the machine frame 20.

An upper slider frame member 38 comprises a frame 39 and a bracket 40, and a ball bush 42 mounted on the frame 39 is supported slidably along a guide shaft 41 fixed to the unit frame 37 and a rod 43 having a spherical joint is vertically moved through other known drive means, for example, directly by a cylinder or through a link mechanism. A cam 44 for vertically moving a push bar, a cam 45 for vertically moving a lower vertically moving a lower slider frame, a chuck lever return cam 46, a cam 47 for opening and closing an inserting guide and a push bar fixing cam 48 are attached to the upper slider frame member 38.

A lower slider frame member 49 comprises a frame 50 as the base member on which inserting and guiding means 27 for holding and guiding a lead of an electronic component when it is inserted into the printed circuit board and a push bar member 52 for pushing the head of the electronic component at the inserting step are mounted. The lower slider frame member 49 is hung down by a link 54 connected to a bell crank 53. Since the bell crank 53 is swung on a fulcrum 56 formed on the unit frame 37 through a roller 55 by the cam 45 for vertically moving the lower slider frame, the lower slider frame member 49 is moved in the vertical direction along the shape of the cam 45 with the vertical movement of the upper slider frame member 38.

The push bar member 52 includes a sleeve 57, an upper bush bar 58 and a lower push bar 59. The sleeve 57 is arranged so that it can be vertically moved along a guide groove 60 by a guide roller 61, and a roller 65 is moved by the cam 44 for vertically moving the push bar through a bell crank 64 swingably supported at a fulcrum 63 of a bracket 62 attached to the frame 50, whereby the push bar member 52 is moved in the vertical direction.

A crank 66 is disposed to fix the upper push bar 58 to the sleeve 57 and is supported on a fulcrum 67 on the sleeve 57, and a force for pressing the upper push bar 58 is given to the crank 66 by a spring 68. The crank 66 is arranged so that while a roller 69 hits on the push bar fixing cam 48, there is a clearance and the upper push bar 58 is not pressed, but when the roller 69 separates from the push bar fixing cam 48 by a relative movement between the upper slider frame member 38 and the sleeve 57, the upper push bar 58 is pressed.

A spring 173 is disposed to move the upper push bar 58 and lower push bar 59 integrally with the sleeve 57. Incidentally, the spring 173 is bent at the time.

An embodiment of the inserting and guiding means 27 is illustrated in Figs. 15 through 18. A structure as shown in U.S. Patent No. 4,054,988, DT—OS 2614002 or DT—OS 2744552 may be used for this inserting and guiding means. In the embodiment of the inserting and guiding means 27 illustrated in Figs. 15 through 18, a block 70 attached to the frame 50 constitutes a basic member and a pair of inserting guides 71 are supported thereon swingably with a pin 72 being as the center. A guide piece 73 is attached to the inside of each inserting guide 71 so that it can turn in a direction perpendicular to the opening direction of the inserting guide 71, and the lead of the electronic component is held between the two guide pieces 73.

When the inserting guide opening and closing cam 47 attached to the upper slider frame member 38 is brought down to hit on a roller 75, a guide opening lever 76 is rotated to push up an operation rod 77, whereby the guide pieces 73 are turned and the inserting guides 71 are opened. When the upper slider frame member 38 is lifted up and the inserting guide opening and closing cam 47 separates from the roller 75, the operation rod 77 is brought down by a guide closing lever 78, whereby the inserting guides 71 are closed and the guide pieces 73 are returned to the original positions.

A bearing 79 is disposed in the interior of the block 70 to guide the lower push bar 59. Reference numeral 80 represents a turning preventing bolt.

The feed means 26 for feeding the electronic component web carrier 2 is a mechanism for intermittently driving one of two ratchet wheels 81 and 82 for guiding and feeding the electronic component web carrier 2 as shown in Fig. 21. The source of this driving force is the vertical movement of the upper slider frame member 38. As shown in Fig. 11, a connecting pin 83 is disposed on the upper slider frame member 38 to extend outwardly through the side plate of the unit frame 37. As shown in Fig. 13, this connecting pin 83 is arranged so that it is allowed to move within a hole 84 having a key hole-like shape. Links 85 and 86 are connected to the connecting pin 83 and the link 86 is swung around a shaft 87 with the vertical movement of the connecting pin 83. The shaft 87 is connected through a oneway clutch 90 to a bevel gear 89 supported in a bearing 88 attached to the side plate of the unit frame 37 as shown in Fig. 19. The bevel gear 89 is engaged with a bevel gear 92 rotatably mounted around a vertical shaft 91, and the bevel gear 92 is connected to the vertical shaft 91 through a slip clutch 93.

The vertical shaft 91 is rotatably supported on a bearing 95 of a block 94 integrated with the unit frame 37, and the ratchet wheel 82 is attached to the lower end of the vertical shaft 91. As shown in Fig. 20, reference numerals 96, 97 and 98 represent a ratchet, a ratchet stopper and a connecting link, respectively, and they are operated by a solenoid 99 as shown in Fig. 13. The solenoid 99 is actuated when the upper slider frame member 38 arrives at the lowermost position, to draw the connecting link 98 and open the ratchet 96.

The state of feeding of the electronic component web carrier is illustrated in Figs. 21, 22 and 23.

The means for cutting the lead 10 into a predetermined length will now be described. As shown in Figs. 21 and 24, a guide block 100 having a front wall inclined to the vertical direction at a predetermined angle, for example, 30° in the present embodiment, to form a guide face 100a is disposed between the ratchet wheels 81 and 82, and the face of the electronic component web carrier 2 which is maintained substantially in the vertical posture by the ratchet wheels 81 and 82 is inclined by 30° when it hits on the guide block 100 and the state shown in Fig. 24 is produced. The electronic component 1 is held by a chuck mechanism, described hereinafter, which is disposed in the transfer means 35, and the lead 10 thereof is cut in the predetermined length by a cutter 102 moved to a fixed blade 101 by a mechanism described hereinafter. Then, only the head portion is transferred to the position of the inserting guides 71 according to a rotary movement with a central shaft 103 being as the center by means of the chuck mechanism described hereinafter and the state 1' is produced.

It is preferred that the inclination angle of the

electronic component web carrier guide face 100a of the guide block 100 be 15 to 45°, especially 25 to 35°. By virtue of the feature that the guide face 100a is thus inclined to the vertical direction and transfer of the electronic component 1 having the lead 10 cut in the predetermined length to the inserting guides 71 is performed by the rotary movement with the central shaft 103 being as the center, the electronic component 1″ fed in the vertical state by the ratchet wheel 81 can be transferred to the inserting guides 71 in the state that electronic component 1′ kept vertical but lowered by ΔH after movement along horizontal distance S.

More specifically, the electronic component is brought down by ΔH while it is moved along horizontal distance S. Accordingly, the stroke of the inserting guides 71 can be correspondingly reduced and the size of the entire structure can be diminished. Furthermore, since this transfer mechanism is a rotating swinging reciprocating mechanism, the structure is very simplified and transfer of electronic components can be performed at a very high speed with an enhanced reliability.

The cutting means for cutting the lead 10 into the predetermined length will now be described by reference to Figs. 10, 25, 26 and 27.

A cam operation cylinder 104 pivoted on the unit frame 37 is connected to a cutting cam 106 having a central shaft 105 on the unit frame 37 and a roller 109 of a lever 108 having a rotation shaft 107 on the unit frame 37 is disposed contiguously to the cutting cam 106. As shown in Fig. 25, a cutter arm 112 is supported swingably around a fulcrum 111 formed on a bracket 110 attached to the unit frame 37, and a bolt 113 is mounted on one end of the cutter arm 112 and a spring 115 is spread between the bolt 113 and a ring 114 around the central shaft 105 (see Fig. 10) so that by the tensile force of the spring 115, a bolt 116 mounted on the cutter arm 112 is caused to hit on the lever 108 and the roller 109 (see Fig. 10) is pressed to the cutting cam 106.

A cutter 102 is attached to the other end of the cutter arm 112 so that the lead of the electronic component located on the electronic component shifting line 117 is cut.

A tooth absence detecting lever 119 rotatable by a pin 118 is disposed on the side of the fixed blade 101 and the lever 119 is projected so that the top end thereof intersects the electronic component shifting line 117. A striker 121 rotatably supported by a pin 120 (see Fig. 26) is disposed to hit on the back face of the detecting lever 119, and the striker 121 is arranged to fall in contact with a limit switch 122 for detecting the absence of teeth. The top end of the detecting lever 119 is always urged by a force of a spring built in the limit switch 122 to intersect the electronic component shifting line 117.

The transfer means 35 for transferring the electronic component 1 separated by the cutting means to the inserting and guiding means 27 is illustrated in Figs. 28 through 35 and the steps of the transfer operation are illustrated in Figs. 36-(a), 36-(b), 36-(c) and 36-(d). The structure of the transfer mechanism will now be described by reference to Figs. 29, 30 and 33. The illustrated state corresponds to the shown Fig. 36-(c).

A shaft 123 is rotatably mounted on the side plate of the unit frame 37, and a lever 124 and a roller 125 are mounted on one end of the shaft 123, and the roller 125 falls in contact with a chuck lever return cam 46. A slip off lever 126 is rotatably mounted on the other end of the shaft 123 and a chuck lever 127 is keyed and supported on the other end of the shaft 123.

As shown in Fig. 33, a horizontal bar 128 is attached to the top end of the chuck lever 127, and a chuck mechanism 129 is attached to the top end of the bar 128. As seen from Figs. 34 and 35 illustrating the chuck mechanism 129 in detail, the chuck mechanism 129 includes a fixed jaw 130 and a pair of movable jaws 133 disposed on both the sides of the fixed jaw 130 so that they can be rotated by a pin 131. The top end of each movable jaw 133 is pressed to the top end of the fixed jaw 130 by a spring 132. A guide groove 134 is formed on each of the movable jaws 133 so that the leads 10 of· the electronic component 1 are gripped by these grooves 134 and are guided in this state. A part of the base of the fixed jaw 130 is laterally projected to form a bracket 135. A hole 136 is formed on the bracket 135 and a spring 137 is attached to draw two vertically inserted pins 138 to each other and hold them in this state. The chuck mechanism 129 having the above-mentioned structure is attached through a hole 143 (see Fig. 34) by means of a pin 142 to a cover plate 141 having a notch 139 on both the sides of which the pins 138 are exposed and being fixed to the bar 128 by a screw 140.

When the chuck mechanism having the above-mentioned structure is pressed to the leads 10, the movable jaws 133 are opened, and when the leads 10 are received in the guide grooves 134, the leads 10 are held and gripped by the force of the spring 132. Accordingly, a particular member need not be disposed to apply a force from the outside to open and close the movable jaws 133. Therefore, the structure can be remarkably simplified and the size and weight of the chuck mechanism can be diminished, and also the sizes of surrounding members can be diminished. As a result, the operation speed can be increased. Moreover, since the pin 138 and spring 137 are disposed in addition to the pin 142, the restrain force is sufficient and this restraint is accompanied by a restoring force, and hence, even if the position of the electronic component to be held and gripped deviates to some extent with respect to

**0 005 468**

the chuck mechanism 129, this deviation can be compensated by the chuck mechanism 129 and the electronic component 1 can be smoothly held and gripped without bending or damaging the lead 10. Furthermore, since some positional error is thus allowed, the positioning of the electronic component web carrier 2 can be remarkably facilitated and centering can be accomplished if only the lead 10 is cut. Therefore, occurrence of the inserting lag caused by a trouble due to the positional error can be effectively prevented.

As shown in Fig. 33, a bracket 144 is attached to the slip off lever 126, and a wiper 145 is attached to this bracket 144. A lead press bar 147 is mounted on the wiper 145 so that the bar 147 can slide around the wiper 145 and receives a force of a spring 146 on one side thereof. A roller 148 is mounted on the terminal end of the lead press bar 147 so that it falls in contact with a lead press bar cam 149 attached to the unit frame 37. An arrangement is made so that when the top end of the lead press bar 147 is projected to the left in the drawing and the lead 10 is guided to the center between the top end of the lead press bar 147 and the top end of the wiper 145 as shown in Fig. 31, a clearance of 0.2 to 0.7 mm is produced between the lead 10 and the wiper 145 and also a clearance of 0.2 to 0.7 mm is produced between the lead 10 and the lead press bar 147.

As the connecting mechanism for determining the positional relationship between the slip off lever 126 and the chuck lever 127, there can be used a delay cam mechanism and a phase difference cam mechanism.

The delay cam mechanism is a mechanism which is arranged so that after the electronic component 1 has been transferred to the inserting guides 71, the chuck lever 127 first begins to return and the slip off lever 126 then begins to return. In the present embodiment, this delay cam mechanism is particularly disposed, and therefore, when the chuck mechanism 129 retreats, even if the chuck mechanism 129 is going to pull and bend the lead 10 of the electronic component 1' held by the inserting guides 71, since the wiper 145 is still left at the acting position, the lead 10 is elastically deformed only slightly and comes to hit on the wiper 145. Accordingly, further deformation of the lead 10 is prevented, and even if the chuck mechanism 129 is retreated at a high speed, the lead 10 is not bent by the chuck mechanism 129 at all. Moreover, a particular mechanism need not be disposed to forcibly open and close the chuck mechanism 129, and it is possible to draw back the chuck mechanism 129 at a high speed by a simple structure such as mentioned above.

This delay cam mechanism includes, as shown in Fig. 29, a cam lever 153 disposed rotatably around a fulcrum 150 formed on the unit frame 37 and having a stopper 152 on one end thereof, a spring 151 for imparting a torque to the cam lever 153, a projection 154 formed on the end portion of the chuck lever 127 and a hook 155 formed on the end portion of the slip off lever 126. The operation of this delay cam mechanism will be described hereinafter.

The phase difference cam mechanism is a mechanism for simultaneously rotating the chuck lever 127 and the slip off lever 126 while maintaining a certain difference of the phase angle produced by the above-mentioned delay cam mechanism. The phase difference cam mechanism includes a lock cam 156 attached to the chuck lever 127, a lock lever 158 disposed rotatably around a pin 157 mounted on the slip off lever 126, and a spring 160 arranged to always bring the lock lever 158 close to a pin 159 mounted on the chuck lever 127 and cause the lock lever 158 to fall in contact with the lock cam 156. The operation of the phase difference cam mechanism will be described hereinafter.

A spring 161 is spread between a pin 162 of the unit frame 37 and the pin 159 of the chuck lever 127 so that when an external force is not applied to the chuck lever 127, the chuck lever 127 is set at the vertical posture or other predetermined posture (for example, at a position of 33° as described hereinafter).

The mechanism for driving the chuck lever 127 will now be described.

When the chuck lever 127 is fed out (the chuck lever 127 is brought down), the cam operating cylinder 104 acts as the drive source as shown in Fig. 10. The cam operating cylinder 104 includes a chuck feed-out cam 164 attached to the central shaft 105, a roller 165 falling in contact with the cam 164 and a lever 167 attached to a shaft 166. The shaft 166 pierces to the opposite side and a gear 168 is attached to the shaft 166 as shown in Fig. 13. A gear 169 is engaged with this gear 168 and a lever 170 is attached to this gear 169. A push bolt 171 is attached to the top end of the lever 170. The terminal portion of the chuck lever 127 is extended to form a crank lever 172.

The mechanism for returning the chuck lever 127 (lifting up the chuck lever 127) includes the above-mentioned chuck lever return cam 46, roller 125, lever 124 (see Fig. 30) and shaft 123.

The operation of the transfer means 35 will now be described.

Fig. 36-(a) shows the state where the electronic component web carrier 2 is caused to hit on the guide face 100a of the guide block 100 and is thereby inclined. At this point, the electronic components 1 are located on the electronic component shifting line 117 of a phase angle of 30°. This state is also shown in the side view of Fig. 28 and the plan view of Fig. 31. In this state, the chuck lever return cam 46 is brought up, but the chuck lever 127 is set at the position of a phase angle of 33° by the force of the spring 161. Accordingly, the phase difference of 3° is maintained by the lock lever 158 which hits on the lock cam 156, and there-

fore, the slip off lever 126 is located at the position of a phase angle of 30° and the wiper 145 and lead press bar 147 stand by on both the sides of the electronic component shifting line 117 of a phase angle 30°. In this state, the electronic component 1 is guided between the wiper 145 and lead press bar 147. An arrangement is made so that at this point, the clearance between the lead 10 of the electronic component 1 and the wiper 145 and between the lead 10 of the electronic component and lead press bar 147 is adjusted to 0.2 to 0.7 mm, respectively.

Then, the cam operating cylinder 104 (see Fig. 10) is actuated to rotate the chuck feed-out cam 164, and the lever 170 is rotated through the above-mentioned mechanism, whereby the crank lever 172 is pressed and the chuck lever 127 is advanced by 3°. This state is shown in Fig. 36-(b) and Fig. 32. Since the phase difference mechanism moves in a coming-off direction, the slip off lever 126 stops at the position of a phase angle of 30°. At this point, the chuck mechanism 129 presses the lead 10 and by this pressing force, the movable jaws 133 are opened. Accordingly, this pressing force is imposed on the lead 10, but since the lead press bar 147 is located just behind the lead 10, only a slight elastic deformation is produced in the lead 10 and a high stress of further deformation is not caused in the lead 10. In this state, the lead 10 is held and gripped by the chuck mechanism 129. By virtue of the above operational function, a particular opening and closing mechanism need be disposed for the chuck mechanism 129, and the operation can be performed at a high speed by a simple, small-size and light-weight mechanism such as mentioned above.

Simultaneously with the above-mentioned operation, the cutter 102 is moved by the action of the cutting cam 106 and an excessive portion of the lead 10 is cut off. At this point, since the cutter 102 is located at a position lower than the position of the fixed blade 101, the lead 10 is going to bend in the falling direction under a lever action owing to the pressing force of the cutter 102, but this bending movement is restricted by a reaction given by the lead press bar 147 and breakage or bending of the lead 10 is prevented. As a result, cutting can be performed at a high speed assuredly.

Then, the cam operation cylinder 104 is elongated to reduce the phase angle to zero, and the electronic component is delivered to the position of the vertical posture by the chuck mechanism 129. This state is shown in Fig. 36-(c), Fig. 29 and Fig. 33. At this point, as shown in Figs. 33 and 36-(c), since the roller 148 comes out of the lead press bar cam 149, the lead pressure bar 147 is retreated.

Then, the upper slider frame member 38 begins to move downwardly. As shown in Fig. 36-(d), the lower slider frame member 49 is lifted up by distance *t* by the first step of the cam 45 for vertically moving the lower slider frame, and the top ends of the inserting guides 71 receive and hold the lead 10 of the electronic component 1. Simultaneously, the sleeve 57 is brought down by the inclined face of the cam 44 for vertically moving the press bar, and the lower press bar 59 is brought down and the head of the electronic component 1 is pressed and tightly held by the lower end of the lower press bar 59. While the rollers 55 and 65 are located in the plane face portion of the cam, the inclined face of the chuck lever return cam 46 presses the roller 125 and the chuck lever 127 begins to return.

At this point, the chuck lever 127 begins to rotate, but since the hook 155 of the slip off lever 126 is caught on the stopper 152 of the cam lever 153 as shown in Fig. 29, the slip off lever 126 is prevented from rotating and the lock cam 156 presses out the lock lever 158 to allow the chuck lever 127 alone to rotate.

At this point, the chuck mechanism 129 is going to draw back the lead 10, but since the wiper 145 is still left just behind the lead 10, the lead 10 is caused to hit on the wiper 145 with a slight deformation alone. Accordingly, breakage or significant deformation of the lead 10 is prevented, and the chuck mechanism can be taken out at a high speed assuredly. Moreover, the structure of the chuck mechanism per se can be simplified.

When the chuck lever 127 arrives at a position of a certain phase angle, for example, 3° (or a retreat distance of 3 mm), the projection 154 raises up the cam lever 153 to take out the hook 155 of the slip off lever 126 from the stopper 152, whereby the slip off lever 126 is returned to the original position in follow-up with the chuck lever 127 by the lock lever 158 while maintaining the phase difference (3° or 3 mm). Before initiation of the return movement of the chuck lever 127, the cam operating cylinder 104 is contracted to lift up the lever 170 so that the return movement of the chuck lever 127 is not inhibited by the lever 170.

After the upper slider frame member 38 has arrived at the lowermost point, it rises again, and also the chuck lever return cam 46 rises and the roller 125 separates from the cam 46. However, the chuck lever 127 is set at the position of a phase angle of 33° by the action of the spring 161 as shown in Fig. 28.

The above procedures are repeated to transfer electronic components one by one in succession.

Operations of means other than the transfer means 35 will now be described.

After the electronic component 1 has been assuredly held by the upward movement of the inserting guides 71 along distance *t* and the downward movement of the lower push bar 59 along distance *m* according to the above-mentioned operation of the transfer means 35, the upper slider frame member 38 further continues the downward movement, and both the rollers 55 and 65 pass through the plane face portion of the cam and ride over the inclined face portion and the inserting guides 71 and the lower push bar 59 are brought down at the same speed. When the lower ends of the inserting guides 71 are going to fall in contact with the printed circuit board 8, the downward movement of the lower slider frame member 49 is stopped by the stopper and the lower ends of the inserting guides 71 are stopped slightly above the printed circuit board 8. Although the upper slider frame member 38 still continues the downward movement, since no restraint is imposed on the roller 55 any more, the lower slider frame member 49 is kept stationary, that is, the inserting guides 71 are kept stationary. In this state, the lower push bar 59 continues the downward movement, and the electronic component 1 is inserted into a predetermined hole on the printed circuit board 8.

In the table unit 22, a lead cutting and bending member as disclosed in, for example, U.S. Patent No. 4,054,988, DT—OS 2614002 or DT—OS 2755290 is disposed on the back side of the printed circuit board 8 to cut off the excessive portion of the lead 10 projecting from the back face of the printed circuit board 8 and bend the cut end of the lead 10 for preventing falling-out of the lead 10. Thus, the electronic component 1 is fixed to the printed circuit board 8.

During the step of stuffing the electronic component 1 into the printed circuit board 8, the inserting guide opening and closing cam 47 hits on the roller 75 and the guide opening lever 76 is operated to open the inserting guides 71 and release the electronic component 1.

When the limit switch detects arrival of the upper slider frame member 38 at the lower end of the stroke, the solenoid 99 (see Fig. 13) for opening the ratchet stopper 97 (see Figs. 19 and 20) is actuated to open the ratchet stopper 97 by the connecting link 98 and set the ratchet wheel 82 free.

Then, the upper slider frame member 38 rises, and also the lower slider frame member 49 is raised up with the rising movement of the upper slider frame member 38 to lift up the inserting guides 71. When the roller 75 of the guide opening lever 76 separates from the inserting guide opening and closing cam 47, the guide closing lever 78 brings down the operating rod 77 to close the inserting guides 71.

By the rising movement of the upper slider frame member 38, the shaft 87 is turned through the links 85 and 86, and the rotating force is transmitted by the one-way clutch 90 to rotate the ratchet wheel 82 intermittently by one pitch.

When the electronic component 1 is transferred to the guide face 100a of the guide block 100, checking is carried out by the tooth absence detecting lever 119 (see Figs. 25 and 26), and when the presence of the electronic component 1 is detected, the power source of the solenoid 99 (see Fig. 13) for opening the ratchet stopper 97 is put off, and the ratchet 96 is fixed by the ratchet stopper 97 and the ratchet wheel 82 is prevented from rotation.

When the upper slider frame member 38 further rises, also the link 86 is further lifted up to rotate the shaft 87, but a slip is caused by the action of the slip clutch 93 and the ratchet wheel 82 is not advanced any more but is stopped at a certain position.

The upper slider frame member 38 stops at the highest point of the stroke, and at this time, a signal for starting the cam operating cylinder 104 is emitted and the above-mentioned procedures are repeated.

As will be apparent from the foregoing illustration, according to the present invention, the speed of inserting electronic components can be remarkably increased (for example, about 1 second is required for insertion of one electronic component according to the conventional technique, but according to the present invention, insertion of one electronic component is accomplished within 1/3 to 1/4 second), and therefore, the operation capacity of the automatically inserting machine can be remarkably increased. Moreover, according to the present invention, the reliability of the automatically inserting machine in the operation of inserting electronic components can be prominently enhanced. Therefore, very high practical effects and advantages can be attained according to the present invention.

## Claims

1. A machine for processing and inserting parallel lead electronic components from an electronic component web carrier carrying a plurality of parallel lead electronic components into lead receiving openings in a printed circuit board, which comprises a frame, feed means for feeding said electronic component web carrier, cutting means for separating each electronic component from said electronic component web carrier, insert means for receiving said each electronic component at a predetermined position and inserting same into said printed circuit board, and transfer means for transferring each said electronic component from said cutting means to said insert means, said transfer means including a lead-chuck mechanism adapted to grip the leads of said electronic component during separation and transfer of each said electronic component characterized in that said cutting means (101, 102) includes a holding member (100a) for holding said leads (10) of said electronic component (1) obliquely to the vertical direction; and that said transfer means (35) includes a horizontal shaft (123), a chuck lever (127) rotatably supported around said horizontal shaft and for holding said lead-chuck mechanism (129), a slip off lever (126), also rotatably supported around said horizontal shaft and a slip off mechanism (145, 147) mounted on said slip off lever, for producing swinging motions between said holding member (100a) of said cutting means (101, 102) and said insert means (21).

2. A machine as set forth in claim 1, wherein means to produce said swinging motions comprises a feed-out mechanism (104, 169, 165, 166, 167) for feeding out said chuck lever (127) and a return mechanism (46, 125, 124, 123) for returning said chuck lever.

3. A machine as set forth in claim 1, wherein said lead-chuck mechanism (129) of said transfer means includes a fixed jaw (130) having spaced substantially parallel opposite sides, a spring and a pair of movable jaws (133) adapted to grasp said fixed jaw (130) from both sides of said fixed jaw via the force of the spring (132), said movable jaws (133) having grooves formed therein for nipping the leads of an electronic component (1) therein, and the slip off mechanism of said transfer means includes a wiper (145) and a lead press bar (147), said wiper and lead press bar being arranged so that they are positionable on both sides of the lead of an electronic component grasped by said lead-chuck mechanism (129), a connecting mechanism between the chuck lever (127) and the slip off lever (126), said chuck lever (127) and said slip off lever (126) being restrained by each other via said connecting mechanism so that said chuck lever and said slip off lever may make relative movements within a predetermined angle range and may move at the same speed, and said lead press bar (147) being arranged so that it is retractable to a position in which it remains out of contact with the lead of the electronic component even if said slip off lever is rotated.

4. A machine as set forth in claim 1, wherein said lead-chuck mechanism (129) is rotatably mounted on said chuck lever (127).

5. A machine as set forth in claim 3, wherein said connecting mechanism comprises a link cam mechanism for moving said slip off lever (126) in dependence on the movement of said chuck lever (127).

6. A machine as set forth in claim 3, wherein said obliquely holding member (100a) holds the electronic components at an angle of inclination of 15° to 45°.

7. A machine as set forth in claim 5, wherein said link cam mechanism includes a delay cam mechanism (150—155) for delaying the time of initiation of the return movement of said slip off lever (126) after the time of initiation of the return movement of said chuck lever (127), the return movement of said chuck lever being initiated after said lead-chuck mechanism (129) has transferred the electronic component to said insert means (27).

8. A machine as set forth in claim 5, wherein said link cam mechanism includes a phase difference cam for maintaining said chuck lever (127) and said slip off lever (126) at a predetermined angular difference.

## Patentansprüche

1. Maschine zum Transportieren elektronischer Bauteile mit parallelen Leitungen von einem gewebten Trägerstreifen, der eine Vielzahl derartiger Bauteile trägt, zu einer Platine einer gedruckten Schaltung und zum Einsetzen der parallelen Leitungen in Leitungsaufnahmeöffnungen der Platine, bestehend aus einem Rahmen, einer Transporteinrichtung für den gewebten Trägerstreifen mit den elektronischen Bauteilen, einer Schneideinrichtung, die jedes elektronische Bauteil vom Trägerstreifen abschneidet, einer Einsetzeinrichtung, die jedes elektronische Bauteil an einer vorbestimmten Stelle in Empfang nimmt und es in die gedruckte Schaltung einsetzt, einer Transporteinrichtung zum Transportieren jedes elektronischen Bauteils von der Schneideinrichtung zu der Einsetzeinrichtung, die einen Leitungseinspannmechanismus einschließt, welcher die Leitungen des elektronischen Bauteils während der Abtrennung und des Transportes ergreift, dadurch gekennzeichnet, daß die Schneideinrichtung (101, 102) ein Halteteil (100a) zum Halten der Leitungen (10) des elektronischen Bauteils (1) schräg zur vertikalen Richtung einschließt, daß die Transporteinrichtung (35) eine horizontale Welle (123), einen drehbar auf der horizontalen Welle gelagerten Einspannhebel (127) zum Halten des Leitungseinspannmechanismus (129), der einen ebenfalls drehbar auf der horizontalen Welle gelagerten Abstreifhebel (126) und einen auf dem Abstreifhebel (126) angeordneten Abstreifmechanismus (145, 147) einschließt, um schwingende Bewegungen zwischen dem Halteteil (100a) der Schneideinrichtung (101, 102) und der Einsetzeinrichtung (21) hervorzurufen.

2. Maschine nach Anspruch 1 dadurch gekennzeichnet, daß die Einrichtung zum Erzeugen dieser schwingenden Bewegungen einen Ausschubmechanismus (104, 169, 165, 166, 167) zum Ausschieben des Einspannhebels (127) und einen Rückholmechanismus (46, 125, 124, 123) zum Rückholen des Einspannhebels (127) einschließt.

3. Maschine nach Anspruch 1 dadurch gekennzeichnet, daß der Leitungseinspannmechanismus (129) der Transporteinrichtung eine feste Backe (130) mit im Abstand einander gegenüberliegenden parallelen Seiten, eine Feder und ein Paar beweglicher Backen (133) einschließt, welche durch die Kraft der Feder (132) beidseitig gegen die feste Backe gedrückt werden, daß in die beweglichen Backen (133) Rillen (134) zum Einspannen der Leitungen eines elektronischen Bauteiles (1) eingeformt sind, und daß der Abstreifmechanismus einen Wischer (145) und eine Leitungspress-Stange (147) einschließt, die so angeordnet sind, daß sie auf beiden Seiten der Leitungen des durch den Leitungseinspannmechanismus (129) festgehalten elektronischen Bauteils positioniert werden können, und daß ein Verbindungsmechanismus zwischen dem Einspannhebel (127) und dem Abstreifhebel (126) vorgesehen ist, wobei der Einspannhebel (127) und der Abstreifhebel (126) durch den Verbindungsmechanismus gegenseitig zurückziehbar sind, so daß der Einspannhebel und der Abstreifhebel relative Bewegungen innerhalb eines vorbestimmten Winkelbereiches machen und mit derselben Geschwindigkeit bewegt werden können, und daß die Leitungsanpress-Stange (147) so angeordnet ist, daß sie in eine Position zurückziehbar ist, in der sie selbst dann außer Kontakt zu den Leitungen des elektronischen Bauteils bleibt, wenn der Abstreifhebel geschwenkt wird.

4. Maschine nach Anspruch 1 dadurch gekennzeichnet, daß der Leitungseinspannmechanismus (129) drehbar auf dem Einspannhebel (127) angeordnet ist.

5. Maschine nach Anspruch 3 dadurch gekennzeichnet, daß der Verbindungsmechanismus einen Hebel-Nocken-Mechanismus einschließt, der den Abstreifhebel (126) in Abhängigkeit vom Einspannhebel (127) bewegt.

6. Maschine nach Anspruch 3 dadurch gekennzeichnet, daß das schräge Halteteil (100a) die elektronischen Bauteile (1) mit einer Winkelabweichung von 15°—45° festhält.

7. Maschine nach Anspruch 5 dadurch gekennzeichnet, daß der Hebel-Nocken-Mechanismus einen verzögerten Nocken-Mechanismus (150—155) zur Verzögerung des Beginns der Rückbewegung des Abstreifhebels (126) hinter den Beginn der Rückbewegung des Einspannhebels (127) einschließt, derart, daß die Rückbewegung des Einspannhebels beginnt, nachdem der Leitungseinspannmechanismus (129) den elektronischen Bauteil zu der Einsetzeinrichtung (27) transportiert hat.

8. Maschine nach Anspruch 5 dadurch gekennzeichnet, daß der Hebel-Nocken-Mechanismus einen Phasen-Differenz-Nocken einschließt, der den Einspannhebel (127) und den Abstreifhebel (126) auf einen vorbestimmten Winkelunterschied hält.

**Revendications**

1. Une machine pour traiter et insérer des composants électroniques à conducteurs parallèles, pris sur un support bande de composants électroniques qui porte une pluralité de composants électroniques à conducteurs parallèles, dans des ouvertures de réception de conducteurs ménagées dans un panneau de circuit imprimé qui comprend un bâti, des moyens d'alimentation servant à faire avancer ledit support bande de composants électroniques, des moyens de coupe servant à séparer chaque composant électronique dudit support bande de composants électroniques, des moyens d'insertion destinés à recevoir chacun desdits composants électroniques dans une position prédéterminée et à l'insérer dans ledit panneau de circuit imprimé, et des moyens de transfert servant à transférer chacun desdits composants électroniques desdits moyens de coupe auxdits moyens d'insertion, lesdits moyens de transfert comprenant un mécanisme de mandrin de conducteurs adapté pour serrer les conducteurs dudit composant électronique pendant la séparation et le transfert de chacun desdits composants électroniques, caractérisée en ce que lesdits moyens de coupe (101, 102) comprennent un organe de retenue (100a) servant à tenir lesdits conducteurs (10) dudit composant électronique (1) obliquement par rapport à la direction verticale; et en ce que lesdits moyens de transfert (35) comprennent un arbre horizontal (123), un levier de mandrin (127) monté rotatif autour dudit arbre horizontal et servant à tenir ledit mécanisme de mandrin de conducteurs (129), un levier de dégagement (126) également monté rotatif autour dudit arbre horizontal et un mécanisme de dégagement (145, 147) monté sur ledit levier de dégagement, pour produire des mouvements d'oscillation entre ledit organe de retenue (100a) desdits moyens de coupe (101, 102) et lesdits moyens d'insertion (21).

2. Une machine comme décrite dans la revendication 1, dans laquelle les moyens servant à produire lesdits mouvements d'oscillation comprennent un mécanisme de sortie (104, 169, 165, 166, 167) servant à faire sortir ledit levier de mandrin (127) et un mécanisme de rappel (46, 125, 124, 123) servant à ramener ledit levier de mandrin.

3. Une machine comme décrite dans la revendication 1, dans laquelle ledit mécanisme de mandrin de conducteurs (129) desdits moyens de transfert comprend une mâchoire fixe (130) ayant des côtés opposés espacés sensiblement parallèles, un ressort et une paire de mâchoires mobiles (133) adaptées pour saisir ladite mâchoire fixe (130) par les deux côtés de ladite mâchoire fixe, par l'intermédiaire de la force du ressort (132), lesdites mâchoires mobiles (133) ayant des gorges (134) qui y sont formées pour y pincer les conducteurs d'un composant électronique (1), et le mécanisme de dégagement desdits moyens de transfert comprend un curseur (145) et une barre presse-conducteurs (147), ledit curseur et ladite barre presse-conducteurs étant agencés de manière à pouvoir être positionnés sur les deux côtés du conducteur d'un composant électronique saisi par ledit mécanisme de mandrin de conducteurs (129), un mécanisme de liaison entre le levier (127) du mandrin et le levier de dégagement (126), ledit levier de mandrin (127) et ledit levier de dégagement (126) étant retenus l'un par l'autre par l'intermédiaire dudit mécanisme de liaison de manière que ledit levier de mandrin et ledit levier de dégagement puissent décrire des mouvements relatifs dans un intervalle angulaire prédéterminé et peuvent se déplacer à la même vitesse, et en ce que ladite barre

**0 005 468**

presse-conducteurs (147) est agencée de manière à pouvoir être rétractée à une position dans laquelle elle reste hors de contact avec le conducteur du composant électronique même si le levier de dégagement est tourné.

4. Une machine comme décrite dans la revendication 1, dans laquelle ledit mécanisme de mandrin de conducteurs (129) est monté rotatif sur ledit levier de mandrin (127).

5. Une machine comme décrite dans la revendication 3, dans laquelle ledit mécanisme de liaison comprend un mécanisme de came à biellette servant à déplacer ledit levier de dégagement (126) en fonction du mouvement dudit levier de mandrin (127).

6. Une machine comme décrite dans la revendication 3, dans laquelle ledit organe de maintien oblique (100a) tient les composants électroniques à un angle d'inclinaison de 15 à 45°.

7. Une machine comme décrite dans la revendication 5, dans laquelle lesdits moyens à came et biellette comprennent un mécanisme de came de retard (150, 155) servant à retarder le temps de déclenchement du mouvement de retour dudit levier de dégagement (126) après l'instant de déclenchement du mouvement de retour dudit levier de mandrin (127), le mouvement de retour dudit levier de mandrin étant déclenché après que ledit mécanisme de mandrin de conducteurs (129) a transféré le composant électronique auxdits moyens d'insertion (27).

8. Une machine comme décrite dans la revendication 5, dans laquelle ledit mécanisme à came et biellette comprend une came de différence de phase servant à maintenir ledit levier de mandrin (127) et ledit levier de dégagement (126) à une différence angulaire prédéterminée.

0 005 468

FIG. 1    FIG. 2

FIG. 3

FIG. 4

FIG. 5

# FIG. 6

# FIG. 7

FIG. 8

25

31

32

33

29

34

FIG. 9

25

31

33

32

36

29

34

# FIG. 10

# F I G. 11

# FIG. 12

# FIG. 13

# FIG. 14

# FIG. 15

# FIG. 16

# FIG. 17

# FIG. 18

# FIG. 19

# FIG. 20

# FIG. 21

2

81

22    22

9

24    24

100

100a

82

23    23

# FIG. 22

1        1

10        10

81

2

# FIG. 23

13  10    11

12  28

81  82  13  10

FIG. 24

FIG. 25

FIG. 26

FIG. 27

FIG. 28

# FIG. 29

FIG. 30

FIG. 31

FIG. 32

18

## FIG. 33

## FIG. 34

## FIG. 35

FIG. 36a

FIG. 36b

20

## FIG. 36c

## FIG. 36d